(19) **Europäisches Patentamt / European Patent Office / Office européen des brevets**

(11) **EP 2 356 424 B1**

(12) **FASCICULE DE BREVET EUROPEEN**

(45) Date de publication et mention
de la délivrance du brevet:
**14.11.2012 Bulletin 2012/46**

(21) Numéro de dépôt: **09768196.9**

(22) Date de dépôt: **16.11.2009**

(51) Int Cl.:
*G01N 3/32* (2006.01)          *G01M 7/02* (2006.01)
*H01L 21/00* (2006.01)          *H05K 3/00* (2006.01)

(86) Numéro de dépôt international:
**PCT/FR2009/052189**

(87) Numéro de publication internationale:
**WO 2010/055272 (20.05.2010 Gazette 2010/20)**

(54) **PROCÉDÉ D'ÉVALUATION DU VIEILLISSEMENT D'UN ENSEMBLE ÉLECTRONIQUE**

VERFAHREN ZUR BEWERTUNG DER ALTERUNG EINER ELEKTRONISCHEN KONSTRUKTION

METHOD OF EVALUATING THE AGEING OF AN ELECTRONIC ASSEMBLY

(84) Etats contractants désignés:
**AT BE BG CH CY CZ DE DK EE ES FI FR GB GR
HR HU IE IS IT LI LT LU LV MC MK MT NL NO PL
PT RO SE SI SK SM TR**

(30) Priorité: **17.11.2008 FR 0857792**

(43) Date de publication de la demande:
**17.08.2011 Bulletin 2011/33**

(73) Titulaire: **European Aeronautic Defence
And Space Company EADS
75016 Paris (FR)**

(72) Inventeurs:
- **GRIEU, Marc
  F-94200 Ivry sur Seine (FR)**
- **MASSIOT, Gregor
  F-31000 Toulouse (FR)**

(74) Mandataire: **Marconnet, Sébastien
SCHMIT CHRETIEN
16, rue de la Paix
75002 Paris (FR)**

(56) Documents cités:
**WO-A-2007/102155**

- **LALL P ET AL: "FailureEnvelope Approach to
  Modeling Shock and Vibration Survivability of
  Electronic and MEMS Packaging" ELECTRONIC
  COMPONENTS AND TECHNOLOGY, 2005. ECTC
  '05. PROCEEDINGS LAKE BUENA VISTA, FL,
  USA MAY 31-JUNE 3, 2005, PISCATAWAY, NJ,
  USA,IEEE, 31 mai 2005 (2005-05-31), pages
  480-490, XP010808696 ISBN: 978-0-7803-8907-6**
- **WANG FRANK FAN ED - AMON C H ET AL:
  "Modified highly accelerated life test for
  aerospace electronics" ITHERM 2002. 8TH.
  INTERSOCIETY CONFERENCE ON THERMAL
  AND THERMOMRCHANICAL PHENOMENA IN
  ELECTRONIC SYSTEMS. SAN DIEGO, CA, MAY
  30 - JUNE 1, 2002; [INTERSOCIETY
  CONFERENCE ON THERMAL AND
  THERMOMECHANICAL PHENOMENA IN
  ELECTRONIC SYSTEMS], NEW YORK, NY :, vol.
  CONF. 8, 30 mai 2002 (2002-05-30), pages
  940-945, XP002452699 ISBN: 978-0-7803-7152-1**
- **PRZEMYSLAW MATKOWSKI ET AL: "Application
  of FPGA units in combined temperature cycle and
  vibration reliability tests of lead-free
  interconnections" ELECTRONICS
  SYSTEMINTEGRATION TECHNOLOGY
  CONFERENCE, 2008. ESTC 2008. 2ND, IEEE,
  PISCATAWAY, NJ, USA, 1 septembre 2008
  (2008-09-01), pages 1375-1380, XP031364687
  ISBN: 978-1-4244-2813-7**

**Description**

L'invention concerne un procédé pour évaluer l'état de vieillissement appelé dommage par fatigue en vibration dans un système électronique quelconque. Il peut s'agir de cartes électroniques individuelles ou d'un ensemble de cartes électroniques. L'évaluation repose sur un dispositif de mesure et de traitement numérique de grandeurs physiques relatives à la sollicitation qui est à l'origine du dommage.

Des dispositifs similaires existent actuellement pour des pièces et structures mécaniques, mais ne disposent pas de certaines caractéristiques nécessaires pour être appliqués aux cartes électroniques. Ces caractéristiques sont la capacité à traiter en temps réel, et de façon autonome avec toute la capacité de calcul embarquée, l'estimation du dommage sans avoir recours ni à de la télémesure, ni à du post-traitement.

La télémesure et le post-traitement de données sont couramment utilisés pour surveiller des aérostructures et des ouvrages d'art, mais les dispositifs correspondants ne répondent pas simultanément aux critères d'embarquabilité et d'autonomie de toute la puissance de calcul.

L'invention repose sur l'association d'un ou plusieurs capteurs cinématiques de la vibration placés en des points particuliers, d'un observateur d'état pour évaluer dynamiquement des contraintes mécaniques localisées en des points critiques et d'un calcul de dommage en ces points critiques, intégrables tous les trois dans un dispositif embarqué et autonome quant à sa fonction. Les points particuliers de mesure et les points critiques de calcul de dommage sont distincts ou confondus selon les applications.

La notion d'observateur d'état trouve sa définition dans les disciplines de l'automatique et de la théorie de l'information. Elle s'applique à des systèmes dynamiques représentés par des grandeurs d'état. Lorsqu'un état d'un système n'est pas accessible à la mesure, on construit un modèle dynamique qui permet de reconstruire l'état non mesurable à partir de mesures d'autres grandeurs accessibles. Ce modèle dynamique s'appelle observateur d'état de la grandeur. Cependant la construction d'un observateur d'état n'est pas toujours possible, et la possibilité d'en construire un s'appelle la condition d'observabilité de cette grandeur.

Dans la présente invention, des grandeurs cinématiques (une accélération ou une vitesse ou une position ou une déformation) de points particuliers de l'ensemble électronique à surveiller sont accessibles à la mesure à l'aide de capteurs, par exemple d'accéléromètres. A l'opposé, des contraintes mécaniques, et plus encore des états de dommage, à des points critiques de l'assemblage électronique sont presque toujours inaccessibles à la mesure, sauf en laboratoire. Un observateur d'état des contraintes mécaniques aux points critiques utilisant la mesure d'une ou plusieurs grandeurs cinématiques en des points particuliers peut être établi, sous réserve d'observabilité. Le caractère observable des contraintes mécaniques dépend directement du ou des points particuliers où sont placés le ou les capteurs cinématiques. En général, il suffit de placer le ou les capteurs cinématiques hors des noeuds de vibration, soit de le(s) placer par exemple sur la fixation de l'ensemble électronique.

Le besoin de savoir évaluer correctement le dommage en vibration sur des cartes électroniques embarquées est de plus en plus prononcé. Ce besoin se rapporte à un certain nombre de points critiques de ces cartes électroniques, auxquels la soumission à des vibrations est susceptible d'entrainer la défaillance de l'ensemble électronique. Par exemple, les points critiques à surveiller sont des joints de brasure de certains composants électroniques. Dans le cas de telles cartes électroniques, des systèmes de surveillance embarqués existent. Ils peuvent être munis d'accéléromètres ou de jauges de déformation pour mesurer des accélérations ou des déformations subies par cette carte. Toutefois, ces capteurs ne peuvent presque jamais être placés aux points critiques de la carte à cause des très petites dimensions des composants, et plus encore, des joints brasés. Les systèmes existants ne peuvent donc pas accéder à la donnée des contraintes mécaniques en ces points critiques. On sait mesurer un état de vieillissement général de la carte, mais on ne sait pas mesurer d'état de fatigue local d'un composant, faute de pouvoir y mettre un capteur qui renseigne sur les contraintes subies par ce composant

L'art antérieur connaît, par la demande de brevet PCT N° WO 2007/102155, un procédé et un système de simulation de fiabilité.

L'art antérieur connaît également, par la publication scientifique LALL P ET AL « Failure-Envelope Approach to Modeling Shock and Vibration Survivability of Electronic and MEMS Packaging », ELECTRONIC COMPONENTS AND TECHNOLOGY, 2005. ECTC '05, PROCEEDINGS LAKE BUENA VISTA, FL, USA MAY 31 - JUNE 3, 2005, PISCATAWAY, NJ, USA, IEEE, 31 mai 2005, pages 480-490, un procédé d'évaluation de fiabilité aux chocs de composants électroniques.

Des méthodes ont été proposées par le laboratoire CALCE, Center for Advanced Life Cycle Engineering, pour faire le lien entre mesure et contraintes aux points critiques. Mais la grande lacune de ces méthodes est de ne pas prendre en compte les effets dynamiques des vibrations. En effet, la méthode proposée par le CALCE néglige la plupart des modes propres de vibration et repose uniquement sur des calculs statiques de courbure. vibration et repose uniquement sur des calculs statiques de courbure.

À l'opposé, la présente invention repose sur des observateurs d'état qui rendent compte des effets dynamiques liés aux forces d'inertie et aux modes propres de vibration de l'ensemble électronique. Le procédé proposé par l'invention exploite beaucoup plus largement les mesures cinématiques pour évaluer le plus fidèlement possible les contraintes mécaniques aux points critiques. Le caractère multiaxial des contraintes mécaniques et la dynamique de l'ensemble électronique sont respectés. L'avantage d'évaluer précisément ces contraintes mécaniques est de pouvoir calculer beaucoup plus précisément le dommage subi par l'ensemble électronique, à l'endroit où sont placés le ou les composants critiques. L'utilisation d'un tel procédé permet d'améliorer les prévisions de maintenance, car l'indication de dommage qu'il délivre sert à anticiper les défaillances potentielles. L'approche proposée permet d'appliquer les principes de la surveillance des structures mécaniques et le traitement numérique des mesures pour connaitre l'état de dommage en plusieurs endroits, grâce à un dispositif embarqué, avec un ou plusieurs capteurs.

Le dispositif intégrant le procédé complet est un petit système électronique embarqué de surveillance (PHM pour Prognostics and Health Management) pourvu d'un ou plusieurs capteurs cinématiques (accélération ou vitesse ou position ou déformation), et d'une unité de calcul. Le système de surveillance est destiné à estimer le dommage lié à une défaillance potentielle des cartes électroniques constituant l'ensemble électronique à surveiller. Le ou les capteurs mesurent une grandeur cinématique en un ou respectivement plusieurs points de l'ensemble électronique à surveiller. Une des fonctions du système de surveillance est l'évaluation, à partir de la ou des mesures du ou des capteurs, de la contrainte mécanique en vibration qui est à l'origine d'une défaillance potentielle. Cette fonction est réalisée par un observateur d'état qui permet de reconstruire la dynamique de la contrainte mécanique à partir d'un modèle dynamique et des mesures cinématiques. La fonction s'opère en temps réel. Le ou les points de mesure et les points d'évaluation des contraintes ne sont pas forcément les mêmes. L'utilisation d'un observateur d'état ne requiert qu'une puissance de calcul de l'unité assez limitée, et le dispositif complet peut ainsi être architecturé autour d'un simple microcontrôleur par exemple. C'est donc le procédé même d'évaluation du vieillissement par fatigue qui permet l'intégration dans un petit dispositif embarqué disposant d'une capacité de calcul autonome.

En pratique, l'observateur d'état peut être réalisé par exemple par une opération de convolution de l'accélération mesurée avec une réponse impulsionnelle en contrainte mécanique. De cette façon, l'ensemble de la bande de fréquence sollicitée est pris en compte, restituant ainsi tous les effets dynamiques. De plus, le caractère multiaxial de la contrainte mécanique est respecté dès lors qu'on utilise une réponse impulsionnelle pour chacune des composantes du tenseur des contraintes. L'observateur d'état pourrait être réalisé autrement que par une opération de convolution : par exemple avec un schéma de résolution d'équation différentielle ou encore en utilisant un modèle à dérivée non-entière (thèse de doctorat de Xavier Moreau, No 95BOR10512, 1995).

L'estimation du dommage repose sur la contrainte mécanique donnée par l'observateur d'état. Par exemple, l'estimation du dommage peut être réalisée par comptage rainflow (décrit dans la norme NF-A03-406, « Fatigue sous sollicitations d'amplitude variable, méthode rainflow de comptage des cycles », novembre 1993, ISSN 0335-3931), et par application de la règle de Palmgren-Miner. La puissance de calcul requise pour ces opérations est très faible, ce qui permet aussi l'intégration dans un dispositif embarqué disposant d'une capacité de calcul autonome.

L'invention a donc pour objet un procédé d'évaluation du vieillissement d'un ensemble électronique, typiquement une carte électronique, soumis à un mouvement vibratoire, procédé dans lequel :

— on mesure une ou plusieurs grandeurs cinématiques, par exemple l'accélération ou la déformation, en un ou plusieurs points particuliers subissant le mouvement vibratoire, par exemple à l'endroit ou aux endroits de sa fixation à un ou des supports,

— on établit un modèle dynamique reliant les grandeurs cinématiques mesurées et des contraintes mécaniques subies en des points critiques au regard de la fatigue en vibration, ce modèle étant appelé observateur d'état,

— on déduit des contraintes mécaniques calculées selon l'observateur d'état un état de dommage de chacun de ces points critiques, états de dommage caractérisant le vieillissement recherché,

— on intègre la chaîne mesures cinématiques-observateur d'état- calcul des états de dommage dans un dispositif embarqué disposant d'une capacité de calcul autonome.

L'invention sera mieux comprise à la lecture de la description qui suit et à l'examen des figures qui l'accompagnent. Celles ci ne sont présentées qu'à titre indicatif et nullement limitatif de l'invention. Les figures montrent :

— figure 1 : un schéma synoptique du procédé de l'invention,
— figure 2 : un exemple pratique d'utilisation de l'invention,
— figure 3 : un exemple d'observateur d'état d'une contrainte mécanique d'un joint brasé d'un composant électronique critique, tiré d'un cas réel.

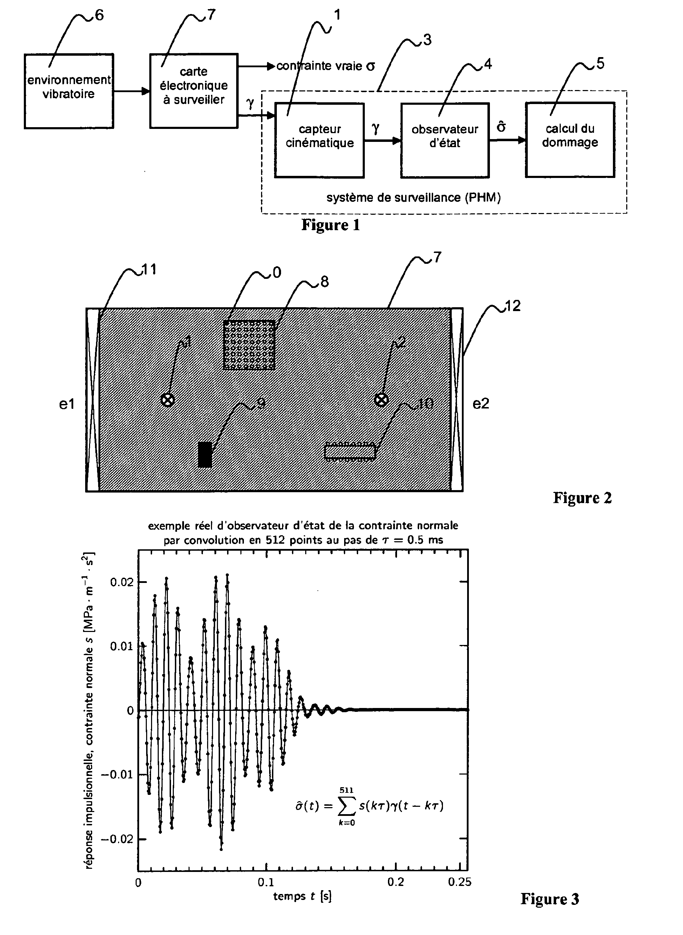

La figure 1 montre qu'un ensemble électronique, par exemple une carte électronique 7, est soumis par un environnement 6 à des vibrations mécaniques. Selon l'invention, le procédé de surveillance, et donc d'évaluation du vieillissement, est mis en oeuvre à l'aide d'un système 3 comportant un capteur cinématique 1, une fonction dite observateur d'état 4 qui traite les signaux $\gamma$ produits par le capteur 1 pour restituer une estimation $\hat{\sigma}$ de la contrainte mécanique

vraie $\sigma$ en un point critique de l'ensemble 7, et une fonction 5 de calcul de dommage en fatigue accumulé en ce point critique de l'ensemble 7 prenant comme variable les résultats $\hat{\sigma}$ produits par l'observateur d'état 4. L'observateur d'état 4 est capable de simuler les conséquences de l'excitation de l'environnement 6 à un endroit choisi alors que le capteur 1 est situé à un autre endroit a priori.

Par exemple, figure 2, l'ensemble 7 est une carte électronique munie de composants utiles 8 à 10, en particulier de composants critiques au sens où leur fonctionnement doit être garanti, et donc surveillé, et sensibles au sens où des vibrations sont susceptibles d'entrainer une défaillance. La carte 7 est fixée dans son support d'utilisation par des fixations telles que 11 à 12. Des capteurs 1 à 2, des accéléromètres ici, mesurent les effets d'excitations e1 à e2 appliquées aux fixations 11 à 12. Selon l'invention, avec l'observateur d'état 4, on est capable d'évaluer les contraintes mécaniques aux endroits sur la carte 7 où sont placés les composants 8 à 10.

Pour simplifier l'explication, on retiendra que les excitations e1 à e2 sont orientées dans une même direction, perpendiculairement à la carte 7, mais ne sont pas nécessairement synchrones. Toutefois, il serait possible de construire un observateur d'état même si cette obligation n'était pas respectée, mais les vibrations selon des directions dans le plan de la carte 7 causent des déformations de beaucoup plus faibles amplitudes qui causent moins de dommage aux composants électroniques. En principe c'est le support qui vibre et qui transmet ses vibrations à la carte par les fixations 11 à 12. Dans un exemple la vibration perpendiculairement à la carte 7 entraine majoritairement des contraintes de traction/compression, ou contraintes normales, sur des joints de brasure 0 d'un composant électronique critique 8 (type BGA, Ball Grid Array) qui conduisent potentiellement à la rupture en traction/compression de ce joint et à la défaillance de la carte électronique 7. Dans l'invention, en particulier si l'accéléromètre est un accéléromètre à trois dimensions, on peut calculer les dommages résultant des trois directions simultanément.

Pour simplifier l'explication, on retiendra aussi que l'ensemble électronique 7 réagit de façon linéaire aux excitations vibratoires. Cela signifie que toute grandeur physique relative à la vibration se comporte de façon additive lorsqu'on superpose plusieurs excitations vibratoires appliquées en des endroits différents ou confondus. Cette restriction n'est pas limitative, car presque tous les ensembles électroniques se comportent ainsi dans la pratique.

Un observateur d'état de la contrainte de traction/compression $\sigma$ au point critique 0 est réalisé par exemple par une opération de convolution entre les mesures d'accélération $\gamma_1$ et $\gamma_2$ des points particuliers 1 et 2, et des réponses impulsionnelles $s_1$ et $s_2$ dont la détermination est précisée plus loin. L'opération de convolution réalisant l'observateur d'état s'écrit :

$$\hat{\sigma}(t) = \sum_{k=0}^{n-1} s_1(k\tau)\gamma_1(t - k\tau) + \sum_{k=0}^{n-1} s_2(k\tau)\gamma_2(t - k\tau)$$

n étant un nombre de points nécessaires et suffisants pour représenter les réponses impulsionnelles $s_1$ et $s_2$, k étant un nombre entier prenant successivement toutes les valeurs de 0 à $n$-1, $\tau$ étant un pas de temps d'échantillonnage des mesures cinématiques, et en notant $\hat{\sigma}(t)$ la contrainte normale évaluée au point critique 0 à l'instant présent t, $\gamma_1(t-k\tau)$ la $k$-ième dernière valeur mesurée de $\gamma_1$ suivant l'échantillonnage au pas de temps $\tau$, $\gamma_2(t-k\tau)$ la $k$-ième dernière valeur mesurée de $\gamma_2$ suivant l'échantillonnage au pas de temps $\tau$, $s_1(k\tau)$ la $k$-ième valeur tabulée de la réponse impulsionnelle $s_1$ selon l'échantillonnage au pas de temps $\tau$, $s_2(k\tau)$ la $k$-ième valeur tabulée de la réponse impulsionnelle $s_2$ selon l'échantillonnage au pas de temps $\tau$, et en utilisant la notation bien connue E désignant une sommation discrète selon une variable discrète et des bornes indiquées en indice et exposant de cette lettre. La variable indiquant le temps présent t est elle-même échantillonnée au pas de temps $\tau$ èt prend donc des valeurs discrètes multiples de $\tau$. L'observateur présenté ici délivre donc à chaque instant t multiple de $\tau$ une estimation $\hat{\sigma}$ de la contrainte mécanique vraie $\sigma$ au point critique 0 dont la mesure directe est presque toujours impossible.

La figure 3 montre un exemple d'observateur d'état sous forme de convolution tiré de l'étude d'une carte électronique réelle. Dans cet exemple, il n'y a qu'une seule excitation vibratoire e1 qui s'applique de façon synchrone sur tous les points de fixation de la carte dans la direction perpendiculaire au plan de la carte. Cette excitation est donc caractérisée par un nombre de degrés de liberté égale à 1. Un seul capteur cinématique est nécessaire et suffisant pour construire un observateur d'état pour chaque composante du tenseur des contraintes en un point critique, sous réserve d'observabilité liée aux positions respectives du capteur et du point critique et aux caractéristiques du capteur. Dans l'exemple de la figure 3, le capteur cinématique est un accéléromètre qui mesure l'accélération $\gamma$ perpendiculairement au plan de la carte, et la contrainte mécanique évaluée $\hat{\sigma}$ est la contrainte normale dans un joint brasé d'un composant électronique de type BGA. Dans cet exemple, le nombre n de points représentant la réponse impulsionnelle est 512, le pas de temps est $\tau$ = 0,5 ms et donc la convolution porte sur une plage de temps de 0,256 s. La dynamique de vibration de la carte électronique est prise en compte sur une plage de fréquence de 0 Hz à 1000 Hz, compte tenu du pas de temps d'échantillonnage $\tau$ = 0,5 ms. Dans cet exemple tiré d'un cas réel, le nombre d'opérations arithmétiques par seconde à réaliser par l'unité de calcul du dispositif de surveillance (PHM) pour la fonction d'observateur d'état du point critique 0 est 1 024 000 multiplications par seconde et 1 024 000 additions par seconde. La capacité de calcul requise pour la fonction d'observateur d'état est donc assez modeste, selon les architectures électroniques actuelles. Le dispositif se passe donc complètement de tout post-traitement ou télémesure, car la technique de calcul utilisée fournit le résultat au prix d'un nombre limité et assez faible de calculs.

On peut remarquer que le nombre de capteurs nécessaires doit généralement être supérieur ou égal au nombre de degrés de liberté d'excitation. Si le nombre de capteur est inférieur, la condition d'observabilité n'est généralement pas vérifiée. Ceci éclaire l'exemple donné en figure 2 avec deux capteurs cinématiques 1 et 2 pour deux excitations vibratoires indépendantes e1 et e2.

Comme annoncé précédemment, un exemple de détermination des réponses impulsionnelles $s_1$ et $s_2$ est donné ci-dessous pour l'exemple de la figure 2. Dans la suite, chaque grandeur portant un tilde ($\sim$) désigne la transformée de Fourier d'une grandeur temporelle. La pulsation, qui est la variable d'une transformée de Fourier, est notée $\omega$ et est homogène à l'inverse d'un temps. L'unité de $\omega$ est usuellement le radian par seconde.

Ainsi, la fonction $\tilde{\gamma}_1(\omega)$ résulte de la transformation de Fourier de la fonction $\gamma_1(t)$, accélération délivrée par le capteur 1. La fonction $\tilde{\gamma}_2(\omega)$ résulte de la transformation de Fourier de la fonction $\gamma_2(t)$, accélération délivrée par le capteur 2. La fonction $\tilde{e}_1(\omega)$ résulte de la transformation de Fourier de la fonction $e_1(t)$, excitation s'appliquant à la fixation 11. La fonction $\tilde{e}_2(\omega)$ résulte de la transformation de Fourier de la fonction $e_2(t)$, excitation s'appliquant à la fixation 12. La fonction $\tilde{\sigma}_0(\omega)$ résulte de la transformation de Fourier de la fonction $\sigma_0(t)$, contrainte mécanique au point critique 0. On note que les transformées de Fourier sont des grandeurs scalaires complexes.

Quatre fonctions $H_{11}(\omega), H_{12}(\omega), H_{21}(\omega), H_{22}(\omega)$ de la pulsation $\omega$ sont définies chacune comme la réponse d'un des points de mesure en terme d'accélération, à une excitation unitaire de pulsation $\omega$ en un des points d'excitation, toutes les autres excitations étant maintenues identiquement nulles. Par la linéarité précisée ci-dessus, ces fonctions s'écrivent de façon générale comme le rapport d'une accélération sur une excitation non nulle qui en est la cause, les autres excitations étant maintenues identiquement nulles. Ce rapport est indépendant l'excitation appliquée à cause de la linéarité précisée plus haut. De façon explicite :

$$H_{11}(\omega) = \left. \frac{\tilde{\gamma}_1(\omega)}{\tilde{e}_1(\omega)} \right|_{e_2=0}$$

$$H_{21}(\omega) = \left. \frac{\tilde{\gamma}_2(\omega)}{\tilde{e}_1(\omega)} \right|_{e_2=0}$$

La notation en indice $e_2$=0 signifie que le rapport est calculé pour l'excitation e1 appliquée seule.

$$H_{12}(\omega) = \left. \frac{\tilde{\gamma}_1(\omega)}{\tilde{e}_2(\omega)} \right|_{e_1=0}$$

$$H_{22}(\omega) = \left. \frac{\tilde{\gamma}_2(\omega)}{\tilde{e}_2(\omega)} \right|_{e_1=0}$$

La notation en indice $e_1$=0 signifie que le rapport est calculé pour l'excitation e2 appliquée seule.

Ces quatre fonctions sont indépendantes des excitations appliquées. Elles peuvent être déterminées expérimentalement, par exemple en procédant successivement aux excitations unitaires dont il est question ci-dessus, en balayant successivement des valeurs de pulsation $\omega$. La méthode des éléments finis, technique de calcul très usuelle et reconnue dans l'industrie, le génie civil et les sciences, offre également des moyens multiples pour déterminer ces quatre fonctions, par exemple en calculant numériquement la procédure expérimentale qui permet de déterminer ces quatre fonctions.

De façon analogue, deux fonctions $G_1(\omega)$ et $G_2(\omega)$ de la pulsation $\omega$ sont définies chacune comme la réponse du point critique 0 en terme de contrainte mécanique, à une excitation unitaire de pulsation $\omega$ en un des points d'excitation, toutes les autres excitations étant maintenues identiquement nulles. Par linéarité, comme précédemment :

$$G_1(\omega) = \left.\frac{\tilde{\sigma}_0(\omega)}{\tilde{e}_1(\omega)}\right|_{e_2=0}$$

$$G_2(\omega) = \left.\frac{\tilde{\sigma}_0(\omega)}{\tilde{e}_2(\omega)}\right|_{e_1=0}$$

La notation en indice $e_1$=0 ou $e_2$=0 signifie que le rapport est calculé pour une excitation appliquée seule. Les deux fonctions G1 et G2 peuvent être déterminées expérimentalement ou par la méthode des éléments finis, comme pour les quatre fonctions précédentes.

Les transformées de Fourier $\tilde{\gamma}_1(\omega)$ et $\tilde{\gamma}_2(\omega)$ des deux accélérations $\gamma_1(t)$ et $\gamma_2(t)$ mesurées par les capteurs 1 et 2 s'écrivent en superposant linéairement les réponses aux deux excitations e1 et e2 :

$$\begin{cases} \tilde{\gamma}_1(\omega) & = & H_{11}(\omega)\tilde{e}_1(\omega) + H_{12}(\omega)\tilde{e}_2(\omega) \\ \tilde{\gamma}_2(\omega) & = & H_{21}(\omega)\tilde{e}_1(\omega) + H_{22}(\omega)\tilde{e}_2(\omega) \end{cases}$$

Ce système scalaire s'écrit sous forme matricielle :

$$\begin{pmatrix} \tilde{\gamma}_1(\omega) \\ \tilde{\gamma}_2(\omega) \end{pmatrix} = \begin{pmatrix} H_{11}(\omega) & H_{12}(\omega) \\ H_{21}(\omega) & H_{22}(\omega) \end{pmatrix} \begin{pmatrix} \tilde{e}_1(\omega) \\ \tilde{e}_2(\omega) \end{pmatrix}$$

Le système matriciel inverse s'écrit :

$$\begin{pmatrix} \tilde{e}_1(\omega) \\ \tilde{e}_2(\omega) \end{pmatrix} = \begin{pmatrix} H_{11}(\omega) & H_{12}(\omega) \\ H_{21}(\omega) & H_{22}(\omega) \end{pmatrix}^{-1} \begin{pmatrix} \tilde{\gamma}_1(\omega) \\ \tilde{\gamma}_2(\omega) \end{pmatrix}$$

où l'exposant -1 indique l'inverse de la matrice. Soit, sous forme de système scalaire :

$$\begin{cases} \tilde{e}_1(\omega) & = & \dfrac{H_{22}(\omega)\tilde{\gamma}_1(\omega) - H_{12}(\omega)\tilde{\gamma}_2(\omega)}{H_{11}(\omega)H_{22}(\omega) - H_{12}(\omega)H_{21}(\omega)} \\[3mm] \tilde{e}_2(\omega) & = & \dfrac{-H_{21}(\omega)\tilde{\gamma}_1(\omega) + H_{11}(\omega)\tilde{\gamma}_2(\omega)}{H_{11}(\omega)H_{22}(\omega) - H_{12}(\omega)H_{21}(\omega)} \end{cases}$$

La transformée de Fourier $\tilde{\sigma}_0(\omega)$ de la contrainte mécanique $\sigma_0$ au point critique 0 s'écrit en superposant linéairement les réponses aux deux excitation $e_1$ et $e_2$ :

$$\tilde{\sigma}_0(\omega) = G_1(\omega)\tilde{e}_1(\omega) + G_2(\omega)\tilde{e}_2(\omega)$$

Cette expression s'écrit alors selon les transformées de Fourier des accélérations :

$$\tilde{\sigma}_0(\omega) \;=\; \frac{G_1(\omega)H_{22}(\omega) - G_2(\omega)H_{21}(\omega)}{H_{11}(\omega)H_{22}(\omega) - H_{12}(\omega)H_{21}(\omega)}\tilde{\gamma}_1(\omega)$$

$$+\frac{-G_1(\omega)H_{12}(\omega) + G_2(\omega)H_{11}(\omega)}{H_{11}(\omega)H_{22}(\omega) - H_{12}(\omega)H_{21}(\omega)}\tilde{\gamma}_2(\omega)$$

On définit alors les deux facteurs devant $\tilde{\gamma}_1(\omega)$, respectivement $\tilde{\gamma}_2(\omega)$ dans l'expression qui précède comme deux fonctions $\tilde{s}_1(\omega)$ et respectivement $\tilde{s}_2(\omega)$ :

$$\tilde{s}_1(\omega) = \frac{G_1(\omega)H_{22}(\omega) - G_2(\omega)H_{21}(\omega)}{H_{11}(\omega)H_{22}(\omega) - H_{12}(\omega)H_{21}(\omega)}$$

$$\tilde{s}_2(\omega) = \frac{-G_1(\omega)H_{12}(\omega) + G_2(\omega)H_{11}(\omega)}{H_{11}(\omega)H_{22}(\omega) - H_{12}(\omega)H_{21}(\omega)}$$

Les réponses impulsionnelles $s_1(t)$ et $s_2(t)$ sont simplement les transformées de Fourier inverses de $\tilde{s}_1(\omega)$ et $\tilde{s}_2(\omega)$ respectivement. On note que $s_1(t)$ et $s_2(t)$ sont des grandeurs scalaires réelles, par leur nature physique. Il y a une raison algébrique à cela qui tient aux propriétés de la transformation de Fourier. $s_1(t)$ et $s_2(t)$ sont les deux fonctions qui, convoluées respectivement avec les mesures $\gamma_1(t)$ et $\gamma_2(t)$, restituent la contrainte mécanique $\sigma_0(t)$ au point critique 0 de l'ensemble électronique 7 :

$$\sigma_0(t) = \int_0^t s_1(u)\gamma_1(t - u)du + \int_0^t s_2(u)\gamma_2(t - u)du$$

La variable $u$ sous le signe intégrale est la variable muette d'intégration.

Une version discrétisée de cette équation intégrale est l'expression donnée plus haut de l'observateur d'état $\hat{\sigma}(t)$. Pour obtenir une telle version discrétisée, il suffit par exemple de substituer les intégrales par des sommations discrètes et de n'utiliser que les valeurs de $s_1$ et $s_2$ prises aux points multiples du pas de temps $\tau$:

$$\hat{\sigma}(t) = \sum_{k=0}^{n-1} s_1(k\tau)\gamma_1(t - k\tau) + \sum_{k=0}^{n-1} s_2(k\tau)\gamma_2(t - k\tau)$$

La discrétisation n'est valable qu'avec un pas de temps suffisamment petit pour représenter correctement les intégrales et les réponses $s_1$ et $s_2$, comme l'illustre la figure 3.

Bien entendu, dans tout ce qui précède, le dénominateur $H_{11}(\omega)H_{22}(\omega)-H_{12}(\omega)H_{21}(\omega)$ ne doit s'annuler pour aucune des valeurs de pulsation $\omega$ dans la plage de fréquence des vibrations. Si c'était le cas, la condition d'observabilité ne serait pas vérifiée : il ne serait pas possible de déduire les excitations à partir des mesures cinématiques, et il faudrait positionner les capteurs cinématiques différemment.

Le calcul précédent n'est qu'une illustration d'une façon de mettre au point un observateur d'état pour une contrainte mécanique d'un point critique. Elle est immédiatement généralisable à un seul capteur ou à un nombre de capteurs supérieur à deux, toujours sous réserve d'observabilité, donc sous réserve que le nombre de voies de mesure soit au moins égal au nombre de degrés de liberté des excitations.

Le calcul par éléments finis repose sur le maillage de la structure géométrique de l'ensemble électronique en éléments polyédriques et sur l'écriture des équations de la mécanique en vibration selon la méthode de Galerkin, appelée aussi formulation faible. La méthode des éléments finis est abondamment documentée dans les revues de mathématiques appliquées et de mécanique. Le calcul peut être réalisé avec l'un des nombreux logiciels du marché. Une présentation de cette technique est disponible dans un article intitulé « Durability Modelling of a BGA Component under Random Vibration » et présenté au congrès EuroSimE à Freiburg-im-Breisgau les 21-23 avril 2008 et accessible sur le site Internet http://ieeexplore.ieee.org/stamp/stamp.jsp?arnumber=4525047&isnumber=4 525005.

Le calcul 5 du dommage est réalisable par exemple selon la méthode rainflow, bien connue (norme NF-A03-406), lorsque la contrainte mécanique évaluée par l'observateur d'état est scalaire. Dans cette méthode, tous les extréma locaux de la contrainte mécanique sont identifiés et un algorithme permet d'identifier des cycles de contrainte mécanique, chaque cycle se définissant par l'un des minima locaux et par l'un des maxima locaux de la contrainte mécanique. Chaque cycle contribue au dommage du point critique 0. Un exemple de calcul du dommage accumulé consiste à utiliser l'hypothèse de Palmgren-Miner, selon laquelle le dommage accumulé est une grandeur scalaire s'incrémentant à chaque cycle d'une valeur qui ne dépend que des caractéristiques du cycle considéré, indépendamment des cycles qui l'ont précédé. Lorsque le dommage attend une valeur seuil, on peut considérer qu'une défaillance du point critique 0 a une probabilité notable de se produire et le dispositif de surveillance est alors en mesure de générer une alarme. Alors, des mesures préventives peuvent être prises avant que la défaillance considérée ne se produise.

Lorsque la contrainte mécanique est plus généralement tensorielle, il existe plusieurs méthodes. L'une d'elle est présentée dans l'article « Durability Modelling of a BGA Component under Random Vibration » précité. Autrement, il existe aussi des méthodes rainflow généralisées aux grandeurs tensorielles. Enfin, on peut citer des critères multiaxiaux de Dang Van et de Sines : voir « Mécanique des matériaux solides », J. Lemaître, J.-L. Chaboche, ISBN 2-10-001397-1.

## Revendications

1. Procédé d'évaluation du vieillissement par fatigue en vibration d'un ensemble électronique, dans lequel

   - on mesure une ou plusieurs grandeurs cinématiques en un ou plusieurs points particuliers subissant le mouvement vibratoire,

   **caractérisé en ce que** :

   - on établit un modèle dynamique reliant les grandeurs cinématiques mesurées et des contraintes mécaniques subies en des points critiques au regard de la fatigue en vibration, ce modèle étant appelé observateur d'état,
   - on déduit des contraintes mécaniques calculées selon l'observateur d'état un état de dommage de chacun de ces points critiques, états de dommage caractérisant le vieillissement recherché,
   - on intègre la chaîne mesures cinématiques-observateur d'état-calcul des états de dommage dans un dispositif embarqué disposant d'une capacité de calcul autonome.

2. Procédé selon la revendication 1, **caractérisé en ce que**

   - un capteur cinématique est placé en un endroit de l'ensemble électronique qui n'est ni une fixation de l'ensemble électronique au support, ni une point critique à surveiller.

3. Procédé selon la revendication 1, **caractérisé en ce que** l'observateur d'état est déterminé par calcul selon la méthode des éléments finis.

4. Procédé selon l'une des revendications 1 à 3, **caractérisé en ce qu'**on place le ou les capteurs en un ou des endroits qui permettent l'observabilité des contraintes mécaniques aux points critiques en se fondant sur l'analyse vibratoire de l'ensemble électronique au moyen de la méthode des éléments finis.

5. Procédé selon l'une des revendications 1 à 4, **caractérisé en ce que**

   - le nombre de points de mesure est supérieur ou égal au nombre de degrés de liberté des excitations.

6. Procédé selon l'une des revendications précédentes, **caractérisé en ce que** ledit ensemble électronique est une carte électronique.

7. Procédé selon l'une des revendications précédentes, **caractérisé en ce que** l'une ou plusieurs grandeurs cinématiques comprend l'accélération.

8. Procédé selon l'une des revendications précédentes, **caractérisé en ce que** l'une ou plusieurs grandeurs cinématiques comprend la déformation.

9. Procédé selon l'une des revendications précédentes, **caractérisé en ce que** l'un ou plusieurs points particuliers subissant le mouvement vibratoire correspond à l'endroit ou aux endroits de sa fixation à un ou des supports.

**Claims**

1. A method of evaluating the vibration fatigue ageing of an electronic assembly, in which

   - one or several kinematic magnitudes are measured at one or several specific points subject to vibratory movement,

   **characterised in that**:

   - a dynamic model is established, relating the kinematic dimensions measured and the mechanical stress suffered at critical points with regard to vibration fatigue, this model being called a state observer,
   - mechanical stress calculated based on the state observer is used to deduce a damage condition for each of these critical points, damage conditions characterising the ageing to be determined,
   - the kinematic measurements - state observer - damage state calculation chain is included in an embedded device having an autonomous calculation capacity.

2. A method according to claim 1, **characterised in that**

   - a kinematic sensor is placed at a location on the electronic assembly that is neither an attachment of the electronic assembly to the holder nor a critical point to be monitored.

3. A method according to claim 1, **characterised in that** the state observer is determined by calculation according to the finite element method.

4. A method according to one of claims 1 to 3, **characterised in that** the sensor(s) are placed at one or more locations that allow for observability of the mechanical stress at the critical points based on the vibratory analysis of the electronic assembly by means of the finite element method.

5. A method according to one of claims 1 to 4, **characterised in that**

   - the number of measurement points is greater than or equal to the number of degrees of freedom of the excitations.

6. A method according to one of the previous claims, **characterised in that** said electronic assembly is an electronic card.

7. A method according to one of the previous claims, **characterised in that** the one or several kinematic dimensions includes acceleration.

8. A method according to one of the previous claims, **characterised in that** the one or several kinematic dimensions includes deformation.

9. A method according to one of the previous claims, **characterised in that** the one or several specific points subject to vibratory movement corresponds to the location or locations of its attachment to one or more holders.

**Patentansprüche**

1. Verfahren zur Bewertung der Alterung einer elektronischen Konstruktion durch Schwingungsermüdung, bei dem

   - man eine oder mehrere kinematische Größen an einem oder an mehreren besonderen Stellen misst, die der Schwingungsbewegung ausgesetzt sind,

**dadurch gekennzeichnet, dass**:

- man ein dynamisches Modell erstellt, welches die gemessenen kinematischen Größen und die mechanischen Beanspruchungen in Verbindung bringt, die an kritischen Stellen angesichts der Schwingungsermüdung hingenommen werden müssen, wobei dieses Modell Zustandsbeobachtungsmodell genannt wird,

- man aus den gemäß dem Zustandsbeobachtungsmodell errechneten mechanischen Beanspruchungen einen Schadenszustand jeder dieser kritischen Stellen ableitet, und die Schadenszustände die gesuchte Alterung charakterisieren,

- man die Kette für Bewegungsmessungen-Zustandsbeobachtung-Berechnung der Schadenszustände in eine eingebaute Vorrichtung integriert, die über eine autonome Rechenkapazität verfügt.

2. Verfahren nach Anspruch 1, **dadurch gekennzeichnet, dass**

e in Bewegungssensor an einer Stelle der elektronischen Konstruktion angebracht wird, die weder eine Befestigung der elektronischen Konstruktion an der Halterung, noch eine kritische Stelle ist, die es zu überwachen gilt.

3. Verfahren nach Anspruch 1, **dadurch gekennzeichnet, dass** die Zustandsbeobachtung durch eine Berechnung nach der Finite-Elemente-Methode bestimmt wird.

4. Verfahren nach einem der Ansprüche 1 bis 3, **dadurch gekennzeichnet, dass** man den oder die Sensoren an einer jener Stellen platziert, die es ermöglichen, die mechanischen Beanspruchungen an den kritischen Stellen zu beobachten, und die sich mit der Schwingungsanalyse der elektronischen Konstruktion anhand der Finite-Elemente-Methode vereinbaren lassen.

5. Verfahren nach einem der Ansprüche 1 bis 4, **dadurch gekennzeichnet, dass**

- die Anzahl der Messstellen größer oder gleich der Anzahl der Freiheitsgrade der Anregungen ist.

6. Verfahren nach einem der vorherigen Ansprüche, **dadurch gekennzeichnet, dass** die besagte elektronische Konstruktion eine Elektronikkarte ist.

7. Verfahren nach einem der vorherigen Ansprüche, **dadurch gekennzeichnet, dass** die eine oder die mehreren kinematischen Größen die Beschleunigung umfasst (umfassen).

8. Verfahren nach einem der vorherigen Ansprüche, **dadurch gekennzeichnet, dass** die eine oder die mehreren kinematischen Größen die Verformung umfasst (umfassen).

9. Verfahren nach einem der vorherigen Ansprüche, **dadurch gekennzeichnet, dass** die eine oder die mehreren besonderen Stellen, die den Schwingungsbewegungen unterliegen, der oder den Befestigungsstellen an der oder den Halterungen entspricht (entsprechen).

**Figure 1**

**Figure 2**

exemple réel d'observateur d'état de la contrainte normale
par convolution en 512 points au pas de $\tau = 0.5$ ms

$$\hat{\sigma}(t) = \sum_{k=0}^{511} s(k\tau)\gamma(t - k\tau)$$

temps $t$ [s]

**Figure 3**

## EP 2 356 424 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2007102155 A

**Littérature non-brevet citée dans la description**

- **LALL P et al.** Failure-Envelope Approach to Modeling Shock and Vibration Survivability of Electronic and MEMS Packaging. *ELECTRONIC COMPONENTS AND TECHNOLOGY, 2005. ECTC '05, PROCEEDINGS LAKE BUENA VISTA, FL, USA MAY 31 - JUNE 3, 2005, PISCATAWAY, NJ, USA, IEEE,* 31 Mai 2005, 480-490
- **XAVIER MOREAU.** *thèse de doctorat,* 1995

- *Fatigue sous sollicitations d'amplitude variable, méthode rainflow de comptage des cycles,* Novembre 1993, ISSN 0335-3931
- *Durability Modelling of a BGA Component under Random Vibration,* 21 Avril 2008, http://ieeexplore.ieee.org/stamp/stamp.jsp?arnumber=4525047&isnumber=4 525005
- Durability Modelling of a BGA Component under Random Vibration. **DANG VAN ; SINES.** Mécanique des matériaux solides